# EUROPEAN PATENT SPECIFICATION

(11) **EP 1 363 403 B1**
(45) Date of publication and mention of the grant of the patent: **17.08.2005**
(21) Application number: 02010952.6
(22) Date of filing: 16.05.2002
(51) Int. Cl.: H03M 1/18, H04B 1/06

(54) **Receiver with an automatic gain control**
Empfangsvorrichtung mit automatischer Verstärkungsregelung
Récepteur avec contrôle automatique de gain

(43) Date of publication of application: 19.11.2003
(73) Proprietor: Sony International (Europe) GmbH, 10785 Berlin (DE)
(72) Inventor: Wildhagen, Jens, Advanced Technology Ct. Stuttgart, 70327 Stuttgart (DE)
(74) Representative: Müller - Hoffmann & Partner

(56) References cited:
- EP-A- 1 061 653
- US-A- 6 160 443
- PATENT ABSTRACTS OF JAPAN vol. 1999, no. 12, 29 October 1999 (1999-10-29) & JP 11 195941 A (HITACHI DENSHI LTD), 21 July 1999 (1999-07-21)
- PATENT ABSTRACTS OF JAPAN vol. 2000, no. 01, 31 January 2000 (2000-01-31) & JP 11 289499 A (MATSUSHITA ELECTRIC IND CO LTD), 19 October 1999 (1999-10-19)

## Description

The invention relates to an amplification and digitisation unit for a receiver, especially for a radio receiver. Furthermore, the invention relates to a method for amplifying and digitising a received signal, preferably a received radio signal.

Receivers often comprise a signal amplification unit, whereby the gain of said unit is controlled by a closed-loop control circuit. The amplified analogue signal is then converted into a digital signal. The amplifier's gain is regulated in a way that the output of the amplifier is equal to a predefined reference level. This implies that the mean input signal of the analogue-digital converter is always constant. The headroom of the mean input signal is usually not varied at all. Thus, the dynamic range of the IF ADC is not optimally exploited in the receiver.

In the European Patent Application EP 1 061 653 A2 "Analog gain control adjustment using a probabilistic algorithm", a method and an apparatus for analog gain control in a transceiver at an end of a data link carrying an analog signal contaminated by radio frequency interference (RFI) is described. From an amplitude distribution of a digital signal output by the ADC, certain predetermined characteristics are extracted and used for adjusting an amplitude of the analog signal to utilise a greater input dynamic range of the ADC.

It is therefore an object of the invention to provide an amplification and digitisation unit for a receiver and a method for amplifying and digitising a received signal, which allow to optimally exploit the dynamic range of the IF ADC independent of the reception situation.

The object of the invention is solved by an amplification and digitisation unit according to claim 1, by a receiver according to claim 13, and by a method for amplifying and digitising a received signal according to claim 15. Referred embodiments thereof are respectively defined in the respective following dependent claims. A computer program product according to the present invention is defined in claim 25.

US 6 160 443 discloses an amplification and digitisation unit for a receiver, preferably for a radio receiver, comprises an amplifier for amplifying a received signal in order to obtain an amplified received signal, an automatic gain control unit, which controls the amplifier's gain, and an analogue-digital converter for converting the amplified received signal into a digital signal for further processing of said received signal and means for varying the mean signal amplitude of the analogue-digital converter's input signal as a function of the reception conditions. According to the invention, the amplification and digitisation unit comprises means for monitoring the reception conditions which track the signal strengths of adjacent channels in order to detect the presence of strong adjacent channels as said reception conditions and further detects instabilities of the received signal's amplitude in order to determine wether the received channel is a fading channel.

In a digital receiver realisation a reception situation dependent selection of the mean signal amplitude leads to an improved performance. The proposed system dynamically changes the mean input amplitude of the analogue-digital converter's input signal. In case of the reception of a signal that is strongly disturbed by a fading channel in combination with no or a low adjacent channel, the mean input signal of the ADC is preferably decreased. Thus, the risk of saturation of the IF ADC is reduced. Moreover, fast gain changes caused by high ADC input amplitudes are reduced, so that the channel equaliser can track the channel more accurate.

On the other hand, in case of the reception of a signal that is strongly disturbed by an adjacent channel, parts of the neighbour channel suppression are performed after the analogue-digital converter. In such a receiver with combined analogue and digital neighbour channel suppression the neighbour channel suppression is limited by the dynamic range of the digitised intermediate frequency signal. The dynamic range of the digitised IF signal depends on the dynamic range of the ADC and the headroom of the ADC input signal. Thus, the neighbour channel suppression can be increased by a decrease of the headroom of the IF ADC input signal. In a digital controlled AGC such a change of the mean input signal can easily be realised.

For the selection of the mean input signal of the ADC input signal, the receiver needs to know about the ratio adjacent channel energy to wanted channel energy and the fading characteristics of the signal. Both information is available in the digital baseband processing part of the receiver. The ratio adjacent channel energy to wanted channel energy can be calculated, for example, from the adjacent channel signal energy that is digitally suppressed in the baseband part. The fading characteristics of the channel can be detected, for example, by a detection of the variation of the IF ADC input energy or by taking into account the information of the AGC time constant control according to patent application EP 0 122 979.6.

The reduction of the headroom of the ADC input signal allows a higher adjacent channel rejection than in case of a high headroom. Thus, the reception situation dependent mean ADC input amplitude selection allows a reception in an environment with high adjacent channel distortions, that is otherwise not possible. The headroom should be chosen in an adaptive process in order to avoid ADC saturation on the one hand and in order to avoid a limitation of the adjacent channel suppression caused by the limited dynamic range of the digitised IF signal on the other hand.

The invention allows to take optimum advantage of the dynamic range of the ADC in every reception situation. According to the invention distortions of the receiver in a fading channel caused by ADC saturation might be reduced on the one hand and the neighbour channel suppression might be increased by an increase of the dynamic range of the digitised intermediate frequency signal on the other hand.

When receiving signals of a certain radio station via the selected channel, it often occurs that there exists a very powerful radio station that transmits radio signals on an adjacent channel. Therefore, according to the present invention, said means for monitoring the reception conditions track the signal strengths of adjacent channels in order to detect the presence of strong adjacent channels to fulfil the task of isolating the desired radio station's signal from the overwhelming background.

Preferably, said means for monitoring the reception conditions detect instabilities of the received signal's amplitude in order to determine whether the received channel is a fading channel. Instabilities and fluctuations of the signal strength on a short time scale are a characteristic feature of a fading channel. Due to reflections, and due to the signal's multipath propagation, the received signal's amplitude is not stable.

According to a first embodiment of the invention, said means for monitoring the reception conditions determine repeatedly how often the amplitude of the analogue-digital converter's input signal exceeds a predetermined threshold. According to this embodiment, a comparator permanently compares the received signal's amplitude with a threshold value. In case the received signal's amplitude often crosses the threshold value from above or below, it can be concluded that the signal strength is fluctuating. By using a separate comparator, it is possible to avoid saturation of the analogue-digital converter.

According to a second embodiment of the invention, said means for monitoring the reception conditions determine how often saturation of the analogue-digital converter occurs. A quick rise of the received signal's amplitude leads to saturation of the analogue-digital converter. The advantage of this embodiment is that no additional circuits are required. All that has to be done is to count the number of saturations during a certain period of time.

According to a third embodiment of the invention, said means for monitoring the reception conditions determine how often said automatic gain control has to readjust the amplifier's gain. The automatic gain control has to keep track of the received signal's amplitude anyway. Also in this embodiment no additional circuitry is necessary for detecting a fading channel.

These embodiments of the invention might be combined in any desired manner. Further, said means for monitoring the reception conditions might alternatively or additionally comprise a channel estimator.

In case the receiver channel is a fading channel, said means for varying the mean signal amplitude decrease said mean signal amplitude of the analogue-digital converter's input signal. By decreasing the mean signal amplitude, the headroom of the input signal is increased, and therefore, even a heavily fluctuating signal will not cause an saturation of the ADC as frequently as before. By reducing the mean signal amplitude, saturation will occur less frequently than before.

According to a further preferred embodiment of the invention, said mean signal amplitude is decreased by lowering the reference value of the automatic gain control. The automatic gain control is implemented as a closed-loop control circuit. The gain is regulated such that the deviation between the mean signal amplitude and the predetermined reference value is minimised. For this reason, the easiest way to change the amplifier's gain is to adjust the reference value of the automatic gain control.

Preferably, said amplification and digitisation unit comprises digital filter means for filtering the amplified digital signal. For performing neighbour channel suppression, the receiver's front-end usually comprises an analogue filter. The allowed bandwidth of said analogue filter must not be chosen too small, because otherwise the quality of the received signal would suffer. For this reason, the digital signal processing unit usually performs an additional digital filter operation with a often variable bandwidth, depending on the received signal. The combination of a first filtering operation within the front-end and a second filtering operation within the digital signal processing unit a good neighbour channel suppression can be achieved. Another advantage is that the digital filter can be implemented such that the signal strengths of adjacent channel that are suppressed by the filter can be determined.

Preferably, said means for monitoring the reception conditions evaluate a ratio of the signal strength of an adjacent channel to the signal strength of the selected channel. A strong neighbour channel can be detected by comparing the signal strength of the neighbour channel to the signal strength of the wanted channel. By calculating the ratio of said signal strengths and comparing said ratio with a predetermined threshold, neighbour channels of considerable strength can be distinguished from less powerful adjacent channels. The threshold can be chosen according to the respective quality requirements.

According to a preferred embodiment of the invention, in case a strong adjacent channel is detected, said means for varying the mean signal amplitude increase said mean signal amplitude of the analogue-digital converter's input signal. The dynamic range of the digitised IF signal depends on the dynamic range of the IF ADC and the headroom of the IF ADC input signal. Thus, the neighbour channel suppression can be increased by a decrease of the headroom of the IF ADC input signal. In a digital controlled AGC such a change of the headroom can easily be realised by increasing the mean signal amplitude of the analogue-digital converter's input signal.

A reduction of the headroom is related to an increased risk of ADC saturation. However, the reduction of the headroom of the ADC input signal allows a higher adjacent channel rejection than in case of a high headroom. Thus, the reception situation dependent mean ADC input amplitude selection allows a reception in an environment with high adjacent channel distortions, that is otherwise not possible. The headroom should be chosen in an adaptive process in order to avoid ADC saturation on the one hand and in order to avoid a limitation of the adjacent channel suppression caused by the limited dynamic range of the digitised IF signal on the other hand.

The headroom increase should be limited to reception situations in which a high adjacent channel rejection is required. Assuming a 40 dB stronger adjacent channel signal than the wanted station and assuming an SNR required for DRM (Digital Radio Mondial) reception is 20 dB, the adjacent channel must provide an SNR of at least 60 dB. Such a strong signal power is, for example, in MW usually only near the transmitter available. In such a reception scenario, it can often be assumed that there is a direct path between the transmitter and the receiver. Thus, the amplitude changes of the adjacent channel caused by a fading channel are not as strong as they are in case of the reception without direct path to the transmitter. As a result, the remaining parts of the adjacent channel signal energy that dominate the IF ADC input signal, have low amplitude variations. For this reason, the headroom of the IF ADC input signal can be decreased as discussed before. Being aware that this statement is not correct in some reception situations, it describes the chances of the reception situation dependent mean ADC input signal selection.

Preferably, said mean signal amplitude is increased by augmenting the reference value of the automatic gain control unit. When the presence of a strong adjacent channel is detected, an augmented reference value is written to the respective reference value register.

The inventive method is related to amplifying and digitising a received signal, preferably a received radio signal. The received signal is amplified in order to obtain an amplified received signal, and the gain of the amplification is controlled by an automatic gain control unit. The amplified received signal is converted to a digital signal by an analogue-digital converter. In a first step, the reception conditions are monitored and the signal strengths of adjacent channels are tracked in order to detect the presence of strong adjacent channels as said reception conditions. Then, the mean signal amplitude of the analogue-digital converter's input signal is varied as a function of said reception conditions.

The method according to the present invention preferably additionally comprises a step of detecting instabilities of the received signal's amplitude in order to determine whether the received channel is a fading channel.

Alternatively or additionally, the method according to the present invention preferably additionally comprises a step of determining repeatedly how often the amplitude of the analogue-digital converter's input signal exceeds a predetermined threshold.

Further alternatively or additionally, the method according to the present invention preferably additionally comprises a step of determining how often saturation of the analogue-digital converter occurs.

Still further alternatively or additionally, in the method according to the present invention said step of monitoring the reception conditions comprises a step of channel estimation.

Still further alternatively or additionally, the method according to the present invention preferably additionally comprises a step of determining how often said automatic gain control has to readjust the amplifier's gain.

Still further alternatively or additionally, the method according to the present invention preferably additionally comprises a step of decreasing said mean signal amplitude of the analogue-digital converter's input signal in case the receiver channel is a fading channel. In this case, the method according to the present invention might additionally comprise a step of lowering the reference value of the automatic gain control.

Still further alternatively or additionally, the method according to the present invention preferably additionally comprises a step of evaluating a ratio of the signal strength of an adjacent channel to the signal strength of the selected channel.

Still further alternatively or additionally, the method according to the present invention preferably additionally comprises a step of increasing said mean signal amplitude of the analogue-digital converter's input signal in case a strong adjacent channel is detected. In this case, the method according to the present invention might additionally comprise a step of augmenting the reference value of the automatic gain control unit.

A computer program product according to the present invention comprises computer program means adapted to perform the method steps as set out above.

Further advantages and features of preferred embodiments according to the present invention will be explained below in conjunction with the accompanying drawings, in which
- **Fig. 1**: shows a block diagram of the receiver according to the invention, whereby the analogue-digital converter's input signal is continuously monitored;
- **Fig. 2**: gives another block diagram of the inventive solution, in which any saturation of the analogue-digital converter is registered;
- **Fig. 3**: shows an example for an automatic gain control with a variable time constant, whereby any variations of said time constant are used for adjusting the gain control's reference level;
- **Fig. 4**: shows several modules within the signal processing unit for detecting the signal strengths of the selected channel and of adjacent channels.

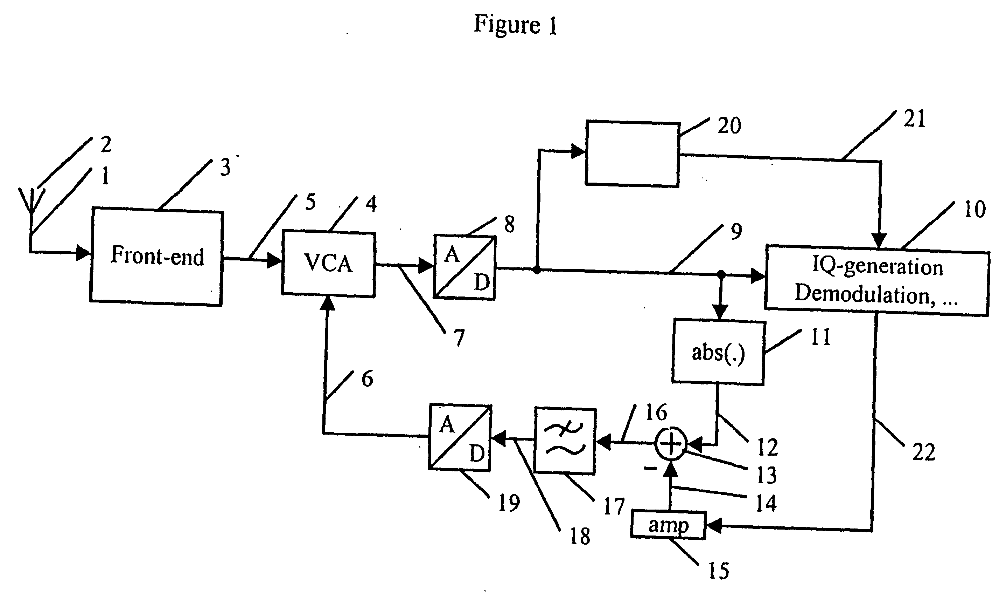

Fig. 1 shows a block diagram of a receiver in which the inventive solution has been implemented. A HF signal 1 is received via an antenna 2. The HF signal 1 is forwarded to a front-end 3, which converts the HF signal to an intermediate frequency. The output signal of the front-end 3 is forwarded to the voltage-controlled amplifier (VCA) 4 as a VCA input signal 5. The voltage-controlled amplifier 4 amplifies the VCA input signal 5, with the amplifier's gain being determined by an analogue gain control signal 6. The analogue VCA output signal is at the same time the input signal 7 of the analogue-digital converter 8. Said analogue-digital converter 8 converts the analogue VCA output signal into a digital VCA output signal 9 that is forwarded to further signal processing units 10 comprising an inphase and quadrature signal generation unit, a demodulation unit, etc.

In the following, it will be described how the analogue gain control signal 6 is obtained. The digital VCA output signal 9 is forwarded to an absolute value determination unit 11, in order to obtain the magnitude 12 of the digital VCA output signal. The reference level value 14 is read out from the register 15 for the reference level, and in the adder 13, the reference level value 14 is subtracted from said magnitude 12. As a result of the subtraction, the error signal 16 is obtained, which gives the deviation of the actual VCA output value from the desired reference level. In the digital low-pass filter 17, the error signal 16 is subjected to a low-pass filtering operation. Preferably, this filter 17 is an integrator. Then, the digital gain control signal 18 at the output of the low-pass filter 17 is forwarded to a digital-analogue converter 19, which transforms the digital gain control signal 18 into the analogue gain control signal 6 that is used for controlling the VCA's amplification.

The reception of a signal may be disturbed by a phenomenon called fading. Due to signal reflections and signal distortions caused by the signal's multipath propagation, the signal strength varies heavily on a small time scale. A channel that is subject to fading will further on be referred to as a "bad fading channel". According to the invention, the mean input amplitude of the analogue-digital converter is decreased in case a bad fading channel is detected.

In the implementation shown in Fig. 1, a "bad fading channel" is detected by monitoring the output signal 9 of the analogue-digital converter. The output signal 9 is connected to a comparator 20, and said comparator 20 determines in regular time intervals whether the value of the output signal 9 is above or below a predefined threshold. In case the selected channel is a fading channel, the value of the output signal 9 will show strong variations on a short time scale. The comparator 20 would detect that for a short period of time, the value of the output signal 9 will be above the threshold, then, it will be below the threshold for an instant, etc. The signal 21, which is forwarded from the comparator 20 to the signal processing unit 10, is a measure of how strong the output signal 9 is fluctuating. The signal processing unit selects the new reference value 22, which is forwarded to the register 15, in dependence of the signal 21. In case the signal 21 indicates that the output signal 9 is a strongly varying signal, the new reference value 22 will be set to a comparatively small value. If the signal 21 indicates that the output signal 9 of the analogue-digital converter is rather stable and that there are only slight variations, the new reference value 22 will be set to a higher value, because the risk of saturation for the analogue-digital converter is small. The gain of the amplifier 4 is controlled such that the mean input value of the analogue-digital converter is equal to the reference value 22.

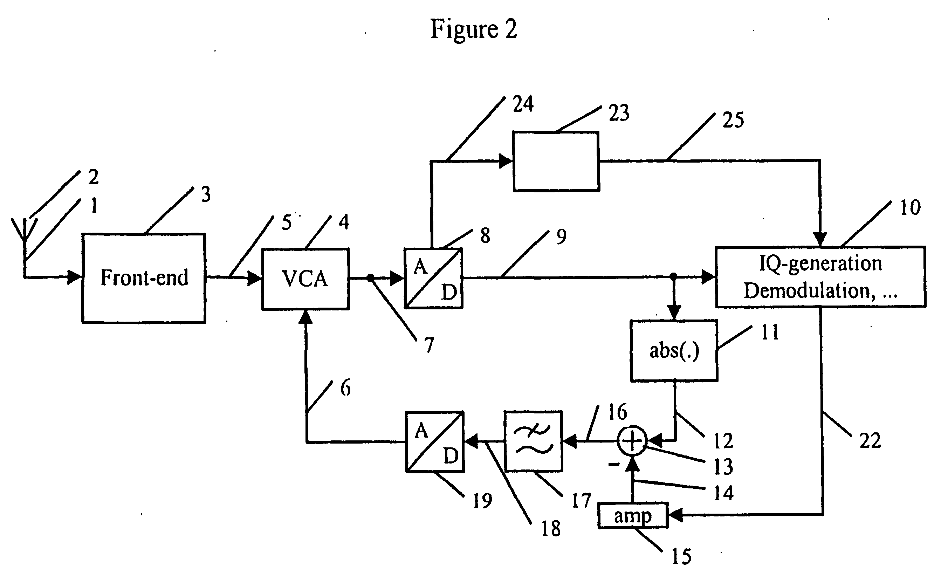

In Fig. 2, a second embodiment of the invention is shown, The closed-loop control circuit for regulating the amplifier's gain is identical to the one shown in Fig. 1, and therefore the same reference signs have been used. The detection of whether or not the received channel is a fading channel is implemented in a different way. In order to detect how strong the input signal 7 of the analogue-digital converter varies, each time a saturation of the analogue-digital converter occurs, the counter 23 is notified via the signal 24. The frequency of ADC saturation is forwarded, by means of the signal 25, to the signal processing unit 10, which selects an adequate reference value 22 for the closed-loop control circuit.

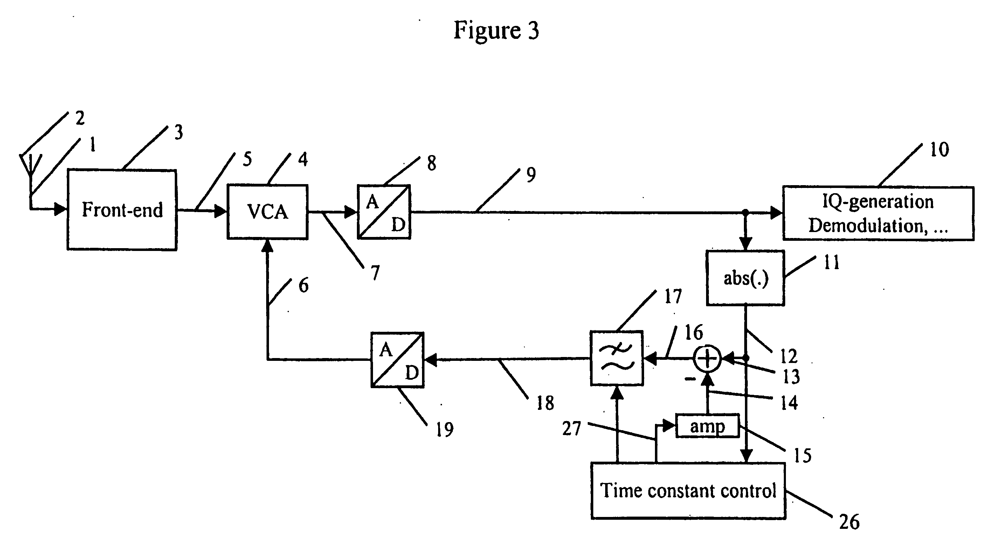

In Fig. 3, a third embodiment of the invention is shown, in which the closed-loop control circuit for controlling the gain comprises a time constant control 26, By means of said time constant control 26, the control rate of the closed-loop control circuit can be varied. By observing the regulation behaviour of said time constant control 26, it is possible to detect whether or not the selected channel is a quickly-varying channel such as a fading channel. The time constant control 26 may also select a new reference value 27 for the closed-loop control circuit, and said reference value 27 is written into the register 15.

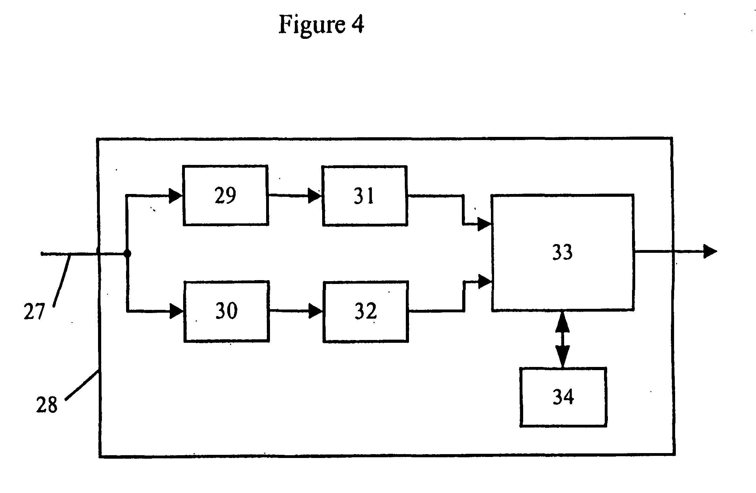

So far, it has been discussed how to detect a strongly varying fading channel. In Fig. 4, it is shown how the presence of a strong adjacent channel can be detected. The digital VCA output signal 27, which corresponds to the output signal 9 of the analogue-digital converter 8 in Figs. 1 to Fig. 3, is forwarded to the digital signal processing unit 28. Within the digital signal processing unit 28, a narrow bandwidth filtering 29 for the selected channel is performed, and a filtering 30 for the adjacent channels is performed as well. Based on the results of the narrow bandwidth filtering 29, a first determination 31 of the selected channel signal strength is performed. Accordingly, a second determination 32 of the adjacent channel signal strength is performed, which is based on the output signal of filtering 30. Means 33 for detecting strong adjacent channels determine the ratio of the signal strength of the adjacent channel to the signal strength of the selected channel. In case said ratio exceeds a predefined threshold, then a strong adjacent channel is found. In this case, according to the invention, the reference value for the mean input signal should be augmented. For this purpose, a table 34 of reference values is accessed and a new reference value is written to the corresponding register.

## Claims

1. Amplification and digitisation unit for a receiver, preferably for a radio receiver, comprising
- an amplifier (4) for amplifying a received signal (5) in order to obtain an amplified received signal (7),
- an automatic gain control unit, which controls the amplifier's gain,
- an analogue-digital converter (8) for converting the amplified received signal (7) into a digital signal (9) for further processing of said received signal (5),
- means for varying the mean signal amplitude of the analogue-digital converter's input signal (7) as a function of the reception conditions,
**characterized in that**
- means for monitoring (20, 23, 33) the reception conditions, which track the signal strengths of adjacent channels in order to detect the presence of strong adjacent channels as said reception conditions, and further
- is adapted in order to detect instabilities/variations of the received signal's amplitude in order to determine whether the received channel is a fading channel.

2. Amplification and digitisation unit according to any one of the preceding claims,
**characterized in that**
said means for monitoring the reception conditions determine repeatedly how often the amplitude of the analogue-digital converter's input signal exceeds a predetermined threshold.

3. Amplification and digitisation unit according to any one of the preceding claims,
**characterized in that**
said means for monitoring the reception conditions determine how often saturation of the analogue-digital converter occurs.

4. Amplification and digitisation unit according to claim 3,
**characterized in that**
said means for monitoring the reception conditions comprise a counter for counting how often saturation of the analogue-digital converter occurs.

5. Amplification and digitisation unit according to any one of the preceding claims,
**characterized in that**
said means for monitoring the reception conditions comprises a channel estimator.

6. Amplification and digitisation unit according to any one of the preceding claims,
**characterized in that**
said means for monitoring the reception conditions determine how often said automatic gain control has to readjust the amplifier's gain.

7. Amplification and digitisation unit according to any one of the preceding claims,
**characterized in that**
in case the receiver channel is a fading channel, said means for varying the mean signal amplitude decrease said mean signal amplitude of the analogue-digital converter's input signal.

8. Amplification and digitisation unit according to claim 7,
**characterized in that**
said mean signal amplitude is decreased by lowering the reference value of the automatic gain control.

9. Amplification and digitisation unit according to any one of the preceding claims,
**characterized in that**
said amplification and digitisation unit comprises digital filter means for filtering the amplified digital signal.

10. Amplification and digitisation unit according to any one of the preceding claims,
**characterized in that**
said means for monitoring the reception conditions evaluate a ratio of the signal strength of an adjacent channel to the signal strength of the selected channel.

11. Amplification and digitisation unit according to any one of the preceding claims,
**characterized in that**
in case a strong adjacent channel is detected, said means for varying the mean signal amplitude increase said mean signal amplitude of the analogue-digital converter's input signal.

12. Amplification and digitisation unit according to claim 11,
**characterized in that**
said mean signal amplitude is increased by augmenting the reference value of the automatic gain control unit.

13. Receiver, comprising an amplification and digitisation unit according to any one of the preceding claims 1 to 12.

14. Receiver according to claim 13,
**characterized in that**
it is adapted in order to receive AM, FM, DAB, or DRM radio signals.

15. Method for amplifying and digitising a received signal, preferably a received radio signal, whereby the received signal (5) is amplified in order to obtain an amplified received signal (7), with the gain of the amplification being controlled by an automatic gain control unit, and whereby the amplified received signal (7) is converted to a digital signal (9) by an analogue-digital converter (8), comprising the following steps of:
- varying the mean signal amplitude of the analogue-digital converter's input signal (7) as a function of the reception conditions
**characterized by**
- monitoring the reception conditions and tracking the signal strengths of adjacent channels in order to detect the presence of strong adjacent channels as said reception conditions, and of
- detecting instabilities/variations of the received signal's amplitude in order to determine whether the received channel is a fading channel.

16. Method according to claim 15.
**characterized by**
a step of determining repeatedly how often the amplitude of the analogue-digital converter's input signal exceeds a predetermined threshold.

17. Method according to any one of the claims 15 and 16.
**characterized by**
a step of determining how often saturation of the analogue-digital converter occurs.

18. Method according to any one of the claims 15 to 17,
**characterized in that**
said step of monitoring the reception conditions comprises a step of channel estimation.

19. Method according to any one of the claims 15 to 18,
**characterized by**
a step of determining how often said automatic gain control has to readjust the amplifier's gain.

20. Method according to any one of the claims 15 to 19,
**characterized by**
a step of decreasing said mean signal amplitude of the analogue-digital converter's input signal in case the receiver channel is a fading channel.

21. Method according to claim 20,
**characterized by**
a step of lowering the reference value of the automatic gain control.

22. Method according to any one of the claims 15 to 21,
**characterized by**
a step of evaluating a ratio of the signal strength of an adjacent channel to the signal strength of the selected channel.

23. Method according to any one of the claims 15 to 22,
**characterized by**
a step of increasing said mean signal amplitude of the analogue-digital converter's input signal in case a strong adjacent channel is detected.

24. Method according to claim 23,
**characterized by**
a step of augmenting the reference value of the automatic gain control unit.

25. Computer program product, comprising computer program means adapted to perform the method steps as defined in any one of claims 15 to 24.

## Patentansprüche

1. Verstärkungs- und Digitalisierungseinheit für eine Empfangsvorrichtung, vorzugsweise einen Funkempfänger, mit:
- einem Verstärker (4) zum Verstärken eines empfangenen Signals (5), um ein verstärktes empfangenes Signal (7) zu erhalten;
- einer automatischen Verstärkungsregelungseinheit, die die Verstärkung des Verstärkers steuert;
- einem Analog-Digital-Wandler (8) zum Wandeln des verstärkten empfangenen Signals (7) in ein digitales Signal (9) zur Weiterverarbeitung des empfangenen Signals (5); und
- einer Einrichtung zum Variieren der mittleren Signalamplitude des Eingangssignals (7) des Analog-Digital-Wandlers als Funktion der Empfangsbedingungen;
**gekennzeichnet durch**
- eine Einrichtung (20, 23, 33) zum Überwachen der Empfangsbedingungen, die die Signalstärken benachbarter Kanäle verfolgt, um das Vorliegen starker Nachbarkanäle als Empfangsbedingungen zu erfassen, und die ferner so ausgebildet ist, dass sie Instabilitäten/Variationen der Amplitude des empfangenen Signals erfasst, um zu ermitteln, ob der empfangene Kanal ein Fadingkanal ist.

2. Verstärkungs- und Digitalisierungseinheit nach einem der vorstehenden Ansprüche, **dadurch gekennzeichnet, dass** die Einrichtung zum Überwachen der Empfangsbedingungen wiederholt ermittelt, wie häufig die Amplitude des Eingangssignals des Analog-Digital-Wandlers einen vorbestimmten Schwellenwert überschreitet.

3. Verstärkungs- und Digitalisierungseinheit nach einem der vorstehenden Ansprüche, **dadurch gekennzeichnet, dass** die Einrichtung zum Überwachen der Empfangsbedingungen ermittelt, wie häufig eine Sättigung des Analog-Digital-Wandlers auftritt.

4. Verstärkungs- und Digitalisierungseinheit nach Anspruch 3, **dadurch gekennzeichnet, dass** die Einrichtung zum Überwachen der Empfangsbedingungen einen Zähler zum Zählen, wie häufig eine Sättigung des Analog-Digital-Wandlers auftritt, aufweist.

5. Verstärkungs- und Digitalisierungseinheit nach einem der vorstehenden Ansprüche, **dadurch gekennzeichnet, dass** die Einrichtung zum Überwachen der Empfangsbedingungen eine Kanal-Abschätzeinheit aufweist.

6. Verstärkungs- und Digitalisierungseinheit nach einem der vorstehenden Ansprüche, **dadurch gekennzeichnet, dass** die Einrichtung zum Überwachen der Empfangsbedingungen ermittelt, wie häufig die automatische Verstärkungsregelung die Verstärkung des Verstärkers neu einstellen muss.

7. Verstärkungs- und Digitalisierungseinheit nach einem der vorstehenden Ansprüche, **dadurch gekennzeichnet, dass** dann, wenn der Empfangsvorrichtungskanal ein Fadingkanal ist, die Einrichtung zum Variieren der mittleren Signalamplitude die mittlere Signalamplitude des Eingangssignals des Analog-Digital-Wandlers verringert.

8. Verstärkungs- und Digitalisierungseinheit nach Anspruch 7, **dadurch gekennzeichnet, dass** die mittlere Signalamplitude durch Verringern des Referenzwerts der automatischen Verstärkungsregelung verringert wird.

9. Verstärkungs- und Digitalisierungseinheit nach einem der vorstehenden Ansprüche, **dadurch gekennzeichnet, dass** sie über eine digitale Filtereinrichtung zum Filtern des verstärkten digitalen Signals verfügt.

10. Verstärkungs- und Digitalisierungseinheit nach einem der vorstehenden Ansprüche, **dadurch gekennzeichnet, dass** die Einrichtung zum Überwachen der Empfangsbedingungen das Verhältnis der Signalstärke eines Nachbarkanals zu derjenigen des ausgewählten Kanals auswertet.

11. Verstärkungs- und Digitalisierungseinheit nach einem der vorstehenden Ansprüche, **dadurch gekennzeichnet, dass** dann, wenn ein starker Nachbarkanal erkannt wird, die Einrichtung zum Variieren der mittleren Signalamplitude die mittlere Signalamplitude des Eingangssignals des Analog-Digital-Wandlers erhöht.

12. Verstärkungs- und Digitalisierungseinheit nach Anspruch 11, **dadurch gekennzeichnet, dass** die mittlere Signalamplitude durch Vergrößern des Referenzwerts der automatischen Verstärkungsregelungseinheit erhöht wird.

13. Empfangsvorrichtung mit einer Verstärkungs- und Digitalisierungseinheit nach einem der vorstehenden Ansprüche 1 bis 12.

14. Empfangsvorrichtung nach Anspruch 13, **dadurch gekennzeichnet, dass** er so ausgebildet ist, dass er AM-, FM-, DAB- oder DRM-Funksignale empfängt.

15. Verfahren zum Verstärken und Digitalisieren eines empfangenen Signals, vorzugsweise eines empfangenen Funksignals, bei dem das empfangene Signal (5) verstärkt wird, um ein verstärktes empfangenes Signal (7) zu erhalten, wobei die Verstärkung beim Verstärkungsvorgang durch eine automatische Verstärkungsregelungseinheit kontrolliert wird, und bei dem das verstärkte empfangene Signal (7) durch einen Analog-Digital-Wandler (8) in ein digitales Signal (9) gewandelt wird, mit den folgenden Schritten:
- Variieren der mittleren Signalamplitude des Eingangssignals (7) des Analog-Digital-Wandlers als Funktion der Empfangsbedingungen;
**gekennzeichnet durch**
- Überwachen der Empfangsbedingungen und Verfolgen der Signalstärken benachbarter Kanäle, um das Vorliegen starker Nachbarkanäle als Empfangsbedingungen zu erkennen; und
- Erfassen von Instabilitäten/Variationen der Amplitude des empfangenen Signals, um zu ermitteln, ob der empfangene Kanal ein Fadingkanal ist.

16. Verfahren nach Anspruch 15, **gekennzeichnet durch** einen Schritt zum wiederholten Ermitteln, wie häufig die Amplitude des Eingangssignals des Analog-Digital-Wandlers einen vorbestimmten Schwellenwert überschreitet.

17. Verfahren nach einem der Ansprüche 15 und 16, **gekennzeichnet durch** einen Schritt des Ermittelns, wie häufig eine Sättigung des Analog-Digital-Wandlers auftritt.

18. Verfahren nach einem der Ansprüche 15 bis 17, **dadurch gekennzeichnet, dass** der Schritt des Überwachens der Empfangsbedingungen einen Schritt einer Kanalabschätzung beinhaltet.

19. Verfahren nach einem der Ansprüche 15 bis 18, **gekennzeichnet durch** einen Schritt des Ermittelns, wie häufig die automatische Verstärkungsregelung die Verstärkung des Verstärkers neu einstellen muss.

20. Verfahren nach einem der Ansprüche 15 bis 19, **gekennzeichnet durch** einen Schritt des Verringerns der mittleren Signalamplitude des Eingangssignals des Analog-Digital-Wandlers dann, wenn der Empfangsvorrichtungskanal ein Fadingkanal ist.

21. Verfahren nach Anspruch 20, **gekennzeichnet durch** einen Schritt des Verringerns des Referenzwerts der automatischen Verstärkungsregelung.

22. Verfahren nach einem der Ansprüche 15 bis 21, **gekennzeichnet durch** einen Schritt des Auswertens des Verhältnisses der Signalstärke eines Nachbarkanals zu derjenigen des ausgewählten Signals.

23. Verfahren nach einem der Ansprüche 15 bis 22, **gekennzeichnet durch** einen Schritt des Erhöhens der mittleren Signalamplitude des Eingangssignals des Analog-Digital-Wandlers dann, wenn ein starker Nachbarkanal erkannt wird.

24. Verfahren nach Anspruch 23, **gekennzeichnet durch** einen Schritt des Erhöhens des Referenzwerts der automatischen Verstärkungsregelungseinheit.

25. Computerprogrammerzeugnis mit einer Computerprogrammeinrichtung, die so ausgebildet ist, dass sie die in einem der Ansprüche 15 bis 24 definierten Verfahrensschritte ausführt.

## Revendications

1. Unité d'amplification et de numérisation pour un récepteur, de préférence pour un récepteur radio, comprenant
- un amplificateur (4) destiné à amplifier un signal reçu (5) afin d'obtenir un signal reçu amplifié (7),
- une unité de contrôle automatique du gain, qui contrôle le gain de l'amplificateur,
- un convertisseur analogique/numérique (8) destiné à convertir le signal reçu amplifié (7) en un signal numérique (9) en vue du traitement ultérieur dudit signal reçu (5),
**caractérisée en ce que**
un moyen pour faire varier l'amplitude moyenne de signal du signal d'entrée (7) du convertisseur analogique/numérique en fonction des conditions de réception,
et
un moyen pour contrôler (20, 23, 33) les conditions de réception, qui suit les intensités des signaux des canaux adjacents afin de détecter la présence de canaux adjacents forts en tant que conditions de réception,
sont adaptés pour détecter des instabilités/des variations de l'amplitude du signal reçu afin de déterminer si le canal reçu est un canal d'évanouissement ou non.

2. Unité d'amplification et de numérisation selon l'une quelconque des revendications précédentes,
**caractérisée en ce que**
ledit moyen de contrôle des conditions de réception détermine de manière répétée la fréquence à laquelle l'amplitude du signal d'entrée du convertisseur analogique/numérique dépasse un seuil prédéterminé.

3. Unité d'amplification et de numérisation selon l'une quelconque des revendications précédentes,
**caractérisée en ce que**
ledit moyen de contrôle des conditions de réception détermine la fréquence à laquelle une saturation du convertisseur analogique/numérique se produit.

4. Unité d'amplification et de numérisation selon la revendication 3,
**caractérisée en ce que**
ledit moyen de contrôle des conditions de réception comprend un compteur destiné à compter la fréquence à laquelle une saturation du convertisseur analogique/numérique se produit.

5. Unité d'amplification et de numérisation selon l'une quelconque des revendications précédentes,
**caractérisée en ce que**
ledit moyen de contrôle des conditions de réception comprend un estimateur de canal.

6. Unité d'amplification et de numérisation selon 'une quelconque des revendications précédentes,
**caractérisée en ce que**
ledit moyen de contrôle des conditions de réception détermine la fréquence à laquelle ledit contrôle automatique du gain doit réajuster le gain de l'amplificateur.

7. Unité d'amplification et de numérisation selon l'une quelconque des revendications précédentes,
**caractérisée en ce que**
lorsque le canal récepteur est un canal d'évanouissement, ledit moyen de variation de l'amplitude moyenne du signal diminue ladite amplitude moyenne du signal du signal d'entrée du convertisseur analogique/numérique.

8. Unité d'amplification et de numérisation selon la revendication 7,
**caractérisée en ce que**
ladite amplitude moyenne de signal est diminuée en réduisant la valeur de référence du contrôle automatique de gain.

9. Unité d'amplification et de numérisation selon l'une quelconque des revendications précédentes,
**caractérisée en ce que**
ladite unité d'amplification et de numérisation comprend un moyen de filtre numérique destiné à filtrer le signal numérique amplifié.

10. Unité d'amplification et de numérisation selon l'une quelconque des revendications précédentes,
**caractérisée en ce que**
ledit moyen de contrôle des conditions de réception évalue un rapport entre l'intensité de signal d'un canal adjacent et l'intensité de signal du canal sélectionné.

11. Unité d'amplification et de numérisation selon l'une quelconque des revendications précédentes,
**caractérisée en ce que**
lorsqu'un canal adjacent fort est détecté, ledit moyen de variation de l'amplitude moyenne de signal augmente ladite amplitude moyenne de signal du signal d'entrée du convertisseur analogique/numérique.

12. Unité d'amplification et de numérisation selon la revendication 11,
**caractérisée en ce que**
ladite amplitude moyenne de signal est augmentée en augmentant la valeur de référence de l'unité de contrôle automatique du gain.

13. Récepteur, comprenant une unité d'amplification et de numérisation selon l'une quelconque des revendications précédentes 1 à 12.

14. Récepteur selon la revendication 13,
**caractérisé en ce que**
il est adapté pour recevoir des signaux radio AM, FM, DAB ou DRM.

15. Procédé d'amplification et de numérisation d'un signal reçu, de préférence d'un signal radio reçu, moyennant quoi le signal reçu (5) est amplifié afin d'obtenir un signal reçu amplifié (7), avec le gain de l'amplification étant contrôlé par une unité de contrôle automatique du gain, et moyennant quoi le signal reçu amplifié (7) est converti en un signal numérique (9) par un convertisseur analogique/numérique (8), comprenant les étapes suivantes consistant à :
- faire varier l'amplitude moyenne de signal du signal d'entrée du convertisseur analogique/numérique (7) en fonction des conditions de réception,
**caractérisé par**
- le contrôle des conditions de réception et le suivi des intensités de signal des canaux adjacents afin de détecter la présence de canaux adjacents forts en tant que conditions de réception,
et consistant à
- détecter des instabilités/des variations au sein de l'amplitude du signal reçu afin de déterminer si le canal reçu est un canal d'évanouissement ou non.

16. Procédé selon la revendication 15,
**caractérisé par**
une étape de détermination de manière répétée de la fréquence à laquelle l'amplitude du signal d'entrée du convertisseur analogique/numérique dépasse un seuil prédéterminé.

17. Procédé selon l'une quelconque des revendications 15 et 16,
**caractérisé par**
une étape de détermination de la fréquence à laquelle une saturation du convertisseur analogique/numérique se produit.

18. Procédé selon l'une quelconque des revendications 15 à 17,
**caractérisé en ce que**
ladite étape de contrôle des conditions de réception comprend une étape d'estimation de canal.

19. Procédé selon l'une quelconque des revendications 15 à 18,
**caractérisé par**
une étape de détermination de la fréquence à laquelle ledit contrôle automatique de gain doit réajuster le gain de l'amplificateur.

20. Procédé selon l'une quelconque des revendications 15 à 19,
**caractérisé par**
une étape de diminution de ladite amplitude moyenne de signal du signal d'entrée du convertisseur analogique/numérique lorsque le canal récepteur est un canal d'évanouissement.

21. Procédé selon la revendication 20,
**caractérisé par**
une étape de diminution de la valeur de référence du contrôle automatique de gain.

22. Procédé selon l'une quelconque des revendications 15 à 21,
**caractérisé par**
une étape d'évaluation d'un rapport entre l'intensité de signal d'un canal adjacent et l'intensité de signal du canal sélectionné.

23. Procédé selon l'une quelconque des revendications 15 à 22,
**caractérisé par**
une étape d'augmentation de ladite amplitude moyenne de signal du signal d'entrée du convertisseur analogique/numérique lorsqu'un canal adjacent fort est détecté.

24. Procédé selon la revendication 23,
**caractérisé par**
une étape d'augmentation de la valeur de référence de l'unité de contrôle automatique de gain.

25. Produit de programme informatique comprenant un moyen de programme informatique adapté pour effectuer les étapes du procédé définies dans l'une quelconque des revendications 15 à 24.
